# EUROPÄISCHE PATENTANMELDUNG

(11) **EP 0 859 542 A2**
(43) Veröffentlichungstag der Anmeldung: **19.08.1998**
(21) Anmeldenummer: 98102439.1
(22) Anmeldetag: 12.02.1998
(51) Int. Cl.: H05K 13/02

(54) **Zuführeinheit für einen Bestückungsautomaten**

(30) Priorität: 18.02.1997 CH 362/97
(71) Anmelder: Zevatech Trading AG, 2545 Selzach (CH)
(72) Erfinder: Gfeller, Martin, CH 3314 Schalunen (CH); Christen, Otto, CH 4702 Oensingen (CH); Grunder, Emil, CH 4614 Hägendorf (CH)
(74) Vertreter: Zinnecker, Armin, Dipl.-Ing.

(57) **Zusammenfassung**

Bei einer Zuführeinheit (1) für einen Bestückungsautomaten, welche Zuführeinheit (1) zusammen mit und parallel zu anderen, gleichartigen Zuführeinheiten in einer Reihe nebeneinander am Bestückungsautomaten einsetzbar ist, und in welcher Zuführeinheit (1) ein auf einer Spule (21) aufgewickeltes Band (23), welches in periodisch angeordneten Taschen Bauelemente für die Bestückung enthält, mittels eines Transportmechanismus (14, 15) von der Spule (21) abgewickelt und schrittweise an einer Entnahmestelle (13) vorbeitransportiert wird, wobei für die drehbare Lagerung der Spule (21) in der Zuführeinheit (1) eine Spulenaufnahme (19) vorgesehen ist, wird ein einfacher und schneller Austausch der Spule (21) dadurch erreicht, dass die Spulenaufnahme (19) als offener Behälter (33) ausgebildet ist, in welchen die Spule (21) herausnehmbar eingesetzt werden kann.

## Beschreibung

### TECHNISCHES GEBIET

Die vorliegende Erfindung bezieht sich auf das Gebiet der automatischen Bestückungstechnik. Sie betrifft eine Zuführeinheit für einen Bestückungsautomaten, welche Zuführeinheit zusammen mit und parallel zu anderen, gleichartigen Zuführeinheiten in einer Reihe nebeneinander am Bestückungsautomaten einsetzbar ist, und in welcher Zuführeinheit ein auf einer Spule aufgewickeltes Band, welches in periodisch angeordneten Taschen Bauelemente für die Bestückung enthält, mittels eines Transportmechanismus von der Spule abgewickelt und schrittweise an einer Entnahmestelle vorbeitransportiert wird, wobei für die drehbare Lagerung der Spule in der Zuführeinheit eine Spulenaufnahme vorgesehen ist.

Eine derartige Zuführeinheit ist beispielsweise aus den Druckschriften US-A-5,024,720, US-A-5,400,497 oder US-A-5,515,600 bekannt.

### STAND DER TECHNIK

Die automatische Bestückung von elektronischen Schaltungen (PCBs oder dgl.) mittels Bestückungsautomaten ist seit langem bekannt und wird insbesondere dort eingesetzt, wo komplizierte und umfangreiche Schaltungen auch in grosser Stückzahl schnell, effizient und fehlerfrei mit einer grösseren Anzahl von Bauelementen bestückt werden müssen. Die Bauelemente liegen dabei nach Typen getrennt auf einzelnen Bändern vor, die auf Spulen aufgerollt sind und mittels entsprechender Zuführeinheiten (Feeder) schrittweise an einer Entnahmestelle (Pick-up position) vorbeigeführt werden, wo sie von einem Handhabungsautomaten entnommen und an dem zugewiesenen Platz in der Schaltung abgesetzt werden. Die Bauelemente sind dabei auf dem Band einzeln in periodisch hintereinander angeordneten Taschen untergebracht und üblicherweise durch ein darüberliegendes Deckband gegen Herausfallen oder Beschädigung geschützt. Derartige automatische Bestückungsvorrichtungen bzw. Bestückungsautomaten sind beispielsweise aus den US-Patenten 4,610,083, 4,653,664, 5,191,693, 5,289,625 und 5,515,600 bekannt.

Da die zu bestückenden elektronischen Schaltungen in der Regel eine Vielzahl von unterschiedlichen Bauelementen enthalten und für jedes Bauelement in der Regel eine einzelne Zuführeinheit am Bestückungsautomaten benötigt wird, werden die Zuführeinheiten (Feeder) platzsparend in möglichst schmaler Bauweise ausgeführt, damit eine möglichst grosse Anzahl von ihnen nebeneinander am Bestückungsautomaten eingesetzt und von der Entnahmevorrichtung (dem Pick-Up-Kopf) des Bestückungsautomaten in kurzer Zeit erreicht werden können (siehe dazu z.B. die Figuren aus der US-A-5,515,600 oder Fig. 13 aus der EP-A2-0 476 577). Die Mindestbreite der Zuführeinheit wird dabei massgeblich von der Breite des eingesetzten Bandes für die Bauelemente mitbestimmt. Der Platz zwischen den einzelnen Zuführeinheiten ist extrem gering und beträgt nur wenige bis 1 Millimeter.

Es kommt nun während des Betriebes eines solchen Bestückungsautomaten häufig vor, dass in einzelnen Zuführeinheiten die vorgehaltenen Bauelemente zur Neige gehen. Grundsätzlich kann der Nachschub dadurch sichergestellt werden, dass der Bestückungsvorgang unterbrochen wird, dass die betroffene Zuführeinheit aus dem Bestückungsautomaten herausgenommen wird und nach einem Wechsel der Spulen und dem Einlesen der neuen Daten in die Steuerung des Automaten wieder eingesetzt wird.

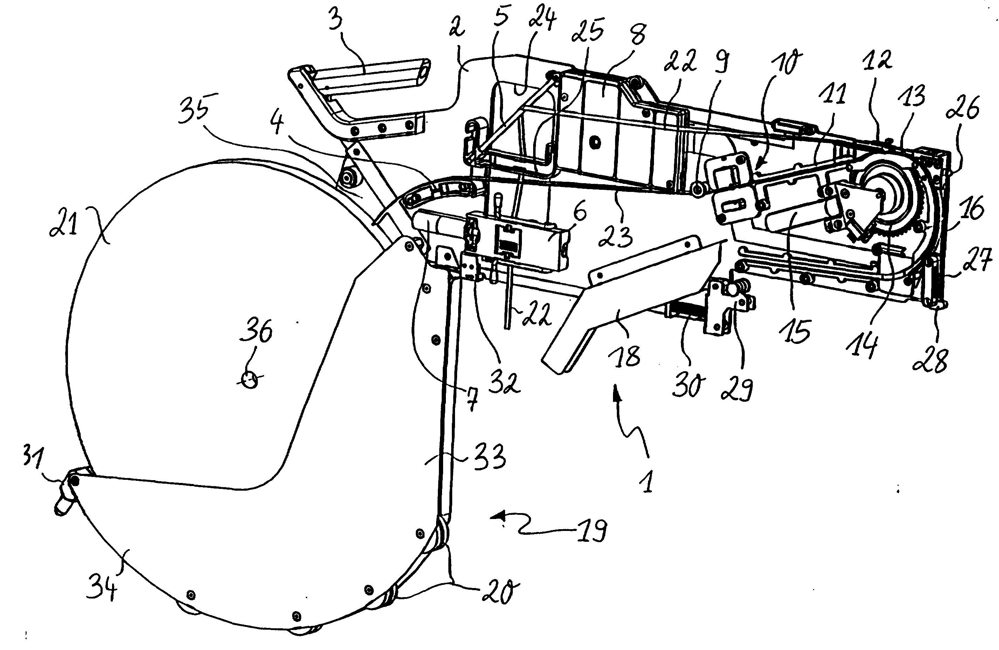

Zur Vermeidung des damit verbundenen Bestückungsleistungs-Verlustes kann aber auch ohne Unterbrechung des gerade laufenden Bestückungsvorgangs (asynchron) die auslaufende Spule aus der am Bestückungsautomaten verbleibenden Zuführeinheit herausgenommen, das Bandende mit dem Anfang eines neuen Bandes auf einer neuen Spule verspleisst, und die neue Spule nach dem Einlesen der Daten in die Zuführeinheit eingesetzt realisiert werden, wenn die drehbare Lagerung der Spule an bzw. in der Zuführeinheit so ausgelegt ist, dass trotz der sehr beengten Platzverhältnisse einfach und schnell auf die Spule zugegriffen und ein Spulenaustausch durchgeführt werden kann. Damit entfällt die herkömmliche Lagerung auf einer ortsfesten zentralen Drehachse, wie sie z.B. aus der US-A-5,400,497 bekannt ist. Eine zentrale Drehachse in einer nach oben verschwenkbaren Spulenhalterung, wie sie aus der US-A-5,515,600 bekannt ist, erleichtert zwar die Ablesung der Spulendaten im montierten Zustand der Zuführeinheiten, ermöglicht jedoch (wie die Fig. 3 erkennen lässt) nicht den Austausch der Spulen in einer montierten Zuführeinheit.

### DARSTELLUNG DER ERFINDUNG

Es ist daher Aufgabe der Erfindung, eine Zuführeinheit zu schaffen, bei welcher ein Auswechseln bzw. Herausnehmen der drehbar gelagerten Spule leicht und schnell möglich ist, ohne dass die Zuführeinheit dazu aus dem Bestückungsautomaten herausgenommen werden muss.

Die Aufgabe wird bei einer Zuführeinheit der eingangs genannten Art dadurch gelöst, dass die Spulenaufnahme als offener Behälter ausgebildet ist, in welchen die Spule herausnehmbar eingesetzt werden kann. Durch die Ausbildung der Spulenaufnahme als offener Behälter kann die Spule ohne zusätzliche Handgriffe oder besondere Vorkehrungen einfach in den Behälter eingesetzt werden oder aus dem Behälter herausgenommen werden. Die Spule muss dabei weder auf irgendwelche Achsen geschoben noch von irgendwelchen Achsen heruntergenommen werden. Die Spule liegt mit ausreichendem Spiel lose in dem Behälter und lässt sich daher leicht bewegen.

Eine erste bevorzugte Ausführungsform der Zuführeinheit nach der Erfindung zeichnet sich dadurch aus, dass der Behälter schräg nach oben und/oder nach vorne offen ist, und dass der Behälter derart ausgebildet ist, dass die Spule teilweise aus dem Behälter frei herausragt. Hierdurch kann die Spule besonders leicht ergriffen und schräg nach oben/vorne aus der Zuführeinheit herausgenommen werden. Gleichzeitig wird dadurch das Ablesen von Datenetiketten erleichtert, die seitlich auf der Spule angeordnet sind.

Eine zweite bevorzugte Ausführungsform der erfindungsgemässen Zuführeinheit ist dadurch gekennzeichnet, dass der Behälter zwei parallel Seitenwände umfasst, dass die Zuführeinheit auf einer Grundplatte aufgebaut ist, und dass die Grundplatte die eine Seitenwand des Behälters bildet. Hierdurch wird die Spulenaufnahme platz- und materialsparend in die Zuführeinheit integriert, wobei das von der Spule abgewickelte Band automatisch die für den Weitertransport in der Zuführeinheit richtige Lage einnimmt.

Eine weitere bevorzugte Ausführungsform der Zuführeinheit nach der Erfindung ist dadurch gekennzeichnet, dass der Behälter Mittel zur drehbaren Lagerung der Spule umfasst, in welche die Spule von oben einsetzbar ist, dass die Mittel zur drehbaren Lagerung eine Mehrzahl von Laufrollen umfassen, welche am Boden des Behälters angeordnet sind, und auf welchen die in den Behälter eingesetzte Spule aufliegt und mit dem Spulenrand abrollt, und dass die Laufrollen auf einem Kreisbogen angeordnet sind, welcher dem Umfangskreis der Spule entspricht.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Die einzige Figur zeigt in perspektivischer Seitenansicht ein bevorzugtes Ausführungsbeispiel für eine Zuführeinheit nach der Erfindung mit eingesetzter Spule.

### WEGE ZUR AUSFÜHRUNG DER ERFINDUNG

In der einzigen Figur ist in perspektivischer Seitenansicht ein bevorzugtes Ausführungsbeispiel einer erfindungsgemässen Zuführeinheit wiedergegeben. Die Zuführeinheit 1 ist auf einer Grundplatte 2 aus Metall aufgebaut, an welche eine Spulenaufnahme 19 in Form eines Behälters 33 angeformt ist. Der Behälter 33 ist nach oben hin bzw. schräg nach vorne hin offen. In ihn kann eine Spule 21 mit dem aufgerollten, die Bauelemente enthaltenden Band eingesetzt werden und sich auf mehreren am Boden des Behälters auf einem (dem Umfangskreis der Spule 21 entsprechenden) Kreisbogen angeordneten Laufrollen 20 frei drehen. Die zentrierte Achse 36 der Spule 21 hat hierbei keine Funktion. Der Behälter 33 weist zwei Seitenwände 34 und 35 auf. Die (hintere) Seitenwand 35 wird von einem Abschnitt der Grundplatte 2 gebildet. Die (vordere) Seitenwand 34 ist ein L-förmig ausgeschnittenes Blechteil, welches parallel verlaufend mit der Grundplatte 2 bzw. der Seitenwand 35 über Abstandhalter verschraubt oder vernietet ist. Die unteren Abstandhalter bilden zugleich die Achsen für die Laufrollen 20. Aufgrund des tiefen Ausschnitts in der Seitenwand 34 ragt ein grosser Teil der Spule 21 frei zugänglich nach oben aus dem Behälter 33 heraus und kann so leicht ergriffen werden. Auch können seitlich auf der Spule 21 angebrachte Datenträger wie z.B. Barcode-Etiketten leicht abgelesen werden. Der Abstand der Seitenwände 34, 35 voneinander ist so gewählt, dass die lose im Behälter 33 liegende Spule 21 seitlich zwar gut geführt ist, aber gleichzeitig ausreichend Spiel hat, um sich leicht drehen und leicht aus dem Behälter 33 herausgenommen werden zu können.

Das Band 23 wird von der Spule 21 weg aus dem Behälter 33 nach oben heraus durch den zentralen Teil der Zuführeinheit 1 nach vorne geführt, wo an einer Entnahmestelle 13 eine (nicht dargestellte) Entnahmevorrichtung eines (nicht dargestellten) Bestückungsautomaten die Bauteile entnimmt.

Unterhalb der Entnahmestelle 13 ist ein von einem Antriebsmotor 15 angetriebenes Transportrad 14 angeordnet. Das Transportrad 14 ist als Zahnrad ausgebildet und greift mit seinen Zähnen in entsprechende Perforationen im Band 23 ein. Der Transport des Bandes 23 durch das Transportrad 14 erfolgt schrittweise und wird von einer elektronischen Steuereinheit 8 gesteuert, die in der Zuführeinheit 1 untergebracht ist. Die Führung des Bandes 23 aus der Spule 21 heraus zum Transportrad 14 hin erfolgt über ein erstes, leicht gekrümmtes Führungselement 4, eine Umlenkrolle 9 und einen ersten Führungskanal 11. Zwischen der Umlenkrolle 9 und dem Eingang des ersten Führungskanals ist ein (optischer) Bandsensor 10 vorgesehen, der zur Detektion des Bandendes oder des Endes eines Bandabschnitts verwendet wird.

Das Band 23 besteht aus einem mit Taschen für die Bauelemente versehenen Trägerband, welches durch ein aufgeklebtes Deckband verschlossen ist. Vor der Entnahmestelle 13 wird mittels einer Abziehvorrichtung 12, wie sie beispielhaft in der US-A-5,213,653 beschrieben ist, das Deckband 22 entgegen der Laufrichtung des Bandes 23 nach hinten abgezogen. Das Trägerband wird hinter der Entnahmestelle 13 durch einen zweiten, gebogenen Führungskanal 16 um das Transportrad 14 herum und durch einen dritten, geraden Führungskanal 17 nach hinten geführt und durch ein weiteres Führungselement 18 nach unten aus der Zuführeinheit 1 herausgelenkt.

Das abgezogene Deckband 22 läuft ohne weitere Führung an der Steuereinheit 8 vorbei zu einer Umlenkwelle 5 und wird dort nach unten umgelenkt und zugleich in der Bandachse um 90° gedreht, so dass die Fläche des Deckbandes 22 hinter der Umlenkwelle 5 in etwa parallel zur Grundplatte 2 orientiert ist. Die kombinierte Umlenkung und Drehung des Deckbandes wird dadurch erreicht, dass die Umlenkwelle 5 in der Ebene des Bandes 23 bzw. des Deckbandes 22 liegt, und dass die Umlenkwelle 5 mit der Laufrichtung des abgezogenen Deckbandes 22 einen Winkel von ungefähr 45° einschliesst.

Die Umlenkwelle 5 ist etwas oberhalb der Grundplatte 2 angeordnet. Damit das umgelenkte Deckband 22 leicht um die Umlenkwelle 5 gelegt und unterhalb der Umlenkwelle 5 sicher an dem dort vorbeilaufenden Band 23 vorbeigeführt werden kann, ist unter der Umlenkwelle 5 und im Bereich zwischen der Umlenkwelle 5 und der Antriebseinheit 6 in der Grundplatte 2 eine Aussparung 24 vorgesehen. Das Deckband 22 wird in seiner um 90° gedrehten Orientierung in der Aussparung 24 an dem Band 23 vorbeigeführt. Zur Führung des Deckbandes 22 in der Aussparung 24 ist ein Führungselement vorgesehen, welches insbesondere die Form eines der zur Richtung des Deckbandes 22 angeordneten, feststehenden Bügels 25 hat.

Das abgezogene Deckband 22 wird mittels einer von einem separaten Antriebsmotor 7 angetriebenen Antriebseinheit 6 transportiert (gezogen), die unterhalb des Bügels 25 am unteren Rand der Aussparung 24 angeordnet ist. Die Antriebseinheit 6 für das Deckband 22 liegt in der Bandebene, d.h., die Antriebsachse verläuft parallel zur Bandebene bzw. zur Grundplatte 2. Zum Einlegen des Deckbandes 22 kann an der Antriebseinheit 6 in an sich bekannter Weise ein aufklappbares Oberteil geöffnet und anschliessend wieder geschlossen werden.

Die Zuführeinheit 1 wird mit dem vorderen Abschnitt, in welchem das Transportrad 14 angeordnet ist, in eine entsprechende Aufnahme im Bestückungsautomaten eingesteckt. Zur Führung und Zentrierung dienen dabei ein oben liegender Führungsstift 26 und eine an der Unterseite angeordnete Führungsnase 28. Eine Verbindung mit dem Bestückungsautomaten zum Austausch elektrische Signale wird durch einen zwischen Führungsstift 26 und Führungsnase 28 plazierten mehrpoligen Steckkontakt 27 hergestellt. Diese Konfiguration ist im wesentlichen bereits aus der US-A-5,024,720 der Anmelderin bekannt.

Die Unterkante der Grundplatte 2 weist im vorderen Bereich der Zuführeinheit 1 einen Absatz auf, an dem eine schwenkbare Einrastklinke 29 angeordnet ist, die mit einem hakenförmigen Fortsatz hinter ein Halteelement am Bestückungsautomaten greift und die Zuführeinheit 1 am Bestückungsautomaten in der eingesetzten Position verriegelt. Die Einrastklinke 29 wird über ein mechanisches Verbindungselement 30 in Form eines Bowdenzuges oder dgl. betätigt bzw. verschwenkt, welches aussen an dem Behälter 33 der Spulenaufnahme 19 entlang (und um die Laufrollen 20 herum) zu einem drehhebelförmigen Betätigungselement 31 geführt ist. Das Betätigungselement 31 sitzt an der äusseren Spitze des Behälters 33. Wenn es betätigt wird, schwenkt die Einrastklinke 29 in ihre Entriegelungsposition und die Zuführeinheit 1 kann mittels des Griffes 3 aus dem Bestückungsautomaten herausgenommen werden. Gleichzeitig wird eine Schalteinrichtung 32 betätigt, die ein entsprechendes Signal an die Steuerung des Bestückungsautomaten abgibt.

Wird nun durch den Bandsensor 10 das Ende des von der Spule 21 abgewickelten Bandes 23 signalisiert, kann das Bedienpersonal, ohne den Bestückungsvorgang unterbrechen und ohne die Zuführeinheit 1 herausziehen zu müssen, aufgrund des leicht zugänglichen Aufbaus der Spulenaufnahme 19 die Spule 21 aus dem Behälter 33 herausnehmen, das Ende des Bandes von der Spule 21 abrollen, den Anfang eines neuen Bandes auf einer neuen Spule mit dem Bandende verspleissen (verkleben), und die neue Spule in den Behälter 33 einsetzen. Hierzu sind keinerlei Veränderungen oder Umbauten an der Zuführeinheit 1 notwendig, so dass dieser Vorgang trotz der räumlichen Enge der vielen parallel einsteckenden Zuführeinheiten schnell und problemlos durchgeführt werden kann.

### BEZEICHNUNGSLISTE

- 1: Zuführeinheit (Feeder)
- 2: Grundplatte
- 3: Griff
- 4: Führungselement (Band)
- 5: Umlenkwelle
- 6: Antriebseinheit (Deckband)
- 7: Antriebsmotor (Deckband)
- 8: Steuereinheit (elektronisch)
- 9: Umlenkrolle
- 10: Bandsensor
- 11,16,17: Führungskanal
- 12: Abziehvorrichtung (Deckband)
- 13: Entnahmestelle
- 14: Transportrad (Band)
- 15: Antriebsmotor (Band)
- 18: Führungselement (Trägerband)
- 19: Spulenaufnahme
- 20: Laufrolle
- 21: Spule
- 22: Deckband
- 23: Band
- 24: Aussparung
- 25: Bügel
- 26: Führungsstift
- 27: Steckkontakt
- 28: Führungsnase
- 29: Einrastklinke
- 30: Verbindungselement
- 31: Betätigungselement
- 32: Schalteinrichtung
- 33: Behälter
- 34,35: Seitenwand
- 36: Achse (Spule)

## Patentansprüche

1. Zuführeinheit (1) für einen Bestückungsautomaten, welche Zuführeinheit (1) zusammen mit und parallel zu anderen, gleichartigen Zuführeinheiten in einer Reihe nebeneinander am Bestückungsautomaten einsetzbar ist, und in welcher Zuführeinheit (1) ein auf einer Spule (21) aufgewickeltes Band (23), welches in periodisch angeordneten Taschen Bauelemente für die Bestückung enthält, mittels eines Transportmechanismus (14, 15) von der Spule (21) abgewickelt und schrittweise an einer Entnahmestelle (13) vorbeitransportiert wird, wobei für die drehbare Lagerung der Spule (21) in der Zuführeinheit (1) eine Spulenaufnahme (19) vorgesehen ist, dadurch gekennzeichnet, dass die Spulenaufnahme (19) als offener Behälter (33) ausgebildet ist, in welchen die Spule (21) herausnehmbar eingesetzt werden kann.

2. Zuführeinheit nach Anspruch 1, dadurch gekennzeichnet, dass der Behälter (33) schräg nach oben und/oder nach vorne offen ist.

3. Zuführeinheit nach einem der Ansprüche 1 und 2, dadurch gekennzeichnet, dass der Behälter (33) derart ausgebildet ist, dass die Spule (21) teilweise aus dem Behälter (33) frei herausragt.

4. Zuführeinheit nach einem der Ansprüche 1 bis 3, dadurch gekennzeichnet, dass
der Behälter (33) zwei parallel Seitenwände (34, 35) umfasst, dass die Zuführeinheit (1) auf einer Grundplatte (2) aufgebaut ist, und dass die Grundplatte (2) die eine Seitenwand (35) des Behälters (33) bildet.

5. Zuführeinheit nach einem der Ansprüche 1 bis 4, dadurch gekennzeichnet, dass das von der Spule (21) abgewickelte Band (23) zum Weitertransport nach oben aus dem offenen Behälter (33) herausgeführt wird.

6. Zuführeinheit nach einem der Ansprüche 1 bis 5, dadurch gekennzeichnet, dass der Behälter (33) Mittel (20) zur drehbaren Lagerung der Spule (21) umfasst, in welche die Spule (21) von oben einsetzbar ist.

7. Zuführeinheit nach Anspruch 6, dadurch gekennzeichnet, dass die Mittel zur drehbaren Lagerung eine Mehrzahl von Laufrollen (20) umfassen, welche am Boden des Behälters (33) angeordnet sind, und auf welchen die in den Behälter (33) eingesetzte Spule (21) aufliegt und mit dem Spulenrand abrollt.

8. Zuführeinheit nach Anspruch 7, dadurch gekennzeichnet, dass die Laufrollen (20) auf einem Kreisbogen angeordnet sind, welcher dem Umfangskreis der Spule (21) entspricht.

9. Zuführeinheit nach einem der Ansprüche 7 oder 8, dadurch gekennzeichnet, dass der Behälter (33) zwei parallele Seitenwände (34, 35) umfasst, dass die Zuführeinheit (1) auf einer Grundplatte (2) aufgebaut ist, dass die Grundplatte (2) die eine Seitenwand (35) des Behälters (33) bildet, dass die andere Seitenwand (34) mittels Abstandshaltern auf der Grundplatte (2) befestigt ist, dass die Laufrollen (20) zwischen den Seitenwänden (34, 35) angeordnet sind und die Achsen der Laufrollen (20) gleichzeitig als Abstandshalter für die Seitenwände (34, 35) dienen.
